# EUROPEAN PATENT SPECIFICATION

(11) **EP 4 180 376 B1**
(45) Date of publication and mention of the grant of the patent: **05.06.2024**
(21) Application number: 21207819.0
(22) Date of filing: 11.11.2021
(51) Int. Cl.: B65H 67/06, H05K 13/02, H05K 13/00

(54) **PICK AND PLACE UNIT FOR A REEL STORAGE CABINET WITH AN ACCESS OPENING**
BESTÜCKUNGSEINHEIT FÜR EINEN ROLLENLAGERSCHRANK MIT ZUGANGSÖFFNUNG
UNITÉ DE BRAS-TRANSFERT POUR UNE ARMOIRE DE STOCKAGE DE BOBINE AYANT UNE OUVERTURE D'ACCÈS

(43) Date of publication of application: 17.05.2023
(73) Proprietor: Totech Europe BV, 8051 TC Hattem (NL)
(72) Inventor: Brehler, Johannes Andries, 8081 PB Elburg (NL)
(74) Representative: 't Jong, Bastiaan Jacob

(56) References cited:
- WO-A1-2018/189699
- WO-A1-2020/048645
- WO-A1-2020/165966
- WO-A1-2021/192408
- JP-A- 2012 134 331
- US-B1- 6 357 983

## Description

The invention relates to a pick and place unit for a reel storage cabinet with an access opening according to the preamble of claim 1. Such a pick and place unit is for example known from WO 2021 192408. WO 2020 165966 also discloses a pick and place unit.

In the production of electronic circuits it is known to supply electronic components onto a carrier tape, which is rolled up on spools and typically known as reels.

Many electronic components, such as resistors, capacitors, diodes, transistors or integrated circuits, are hygroscopic due to their structure and the materials used, so that the components absorb moisture from the ambient air. Therefore, the reels with these electronic components are stored in storage cabinets, in which the air is conditioned, in particular to humidity of for example less than 3% and temperature of for example about 12°C - 14°C. This allows for a long term storage of the components, without any degradation of the components.

When such a storage cabinet is opened in order to store or to retrieve a reel, the ambient air will mix with the air inside of the storage cabinet and the humidity inside of the storage cabinet will rise. This can be counteracted by dehumidifying the air inside of the storage cabinet, but will increase energy costs for each time the storage cabinet is opened.

More general, it is known to store spare parts in storage cabinets, in which large trays are stored on top of each other within a housing and in which a conveyor system can retrieve a single tray and bring it to an access opening, where a person can retrieve a specific part from the tray. This access opening is typically similar in size as the tray, such that parts can easily be stored and retrieved.

These large trays could be used to carry a large number of reels positioned vertically or horizontally. When however, the storage cabinet is opened, i.e. the access opening is opened, a large amount of ambient air will mix with the air inside of the storage cabinet and a relative large amount of energy is required to recondition the air in the storage cabinet. These multi-purpose storage cabinets are substantially lower in costs than storage cabinets specially dedicated for reels, but the energy costs of a multi-purpose storage cabinet is typically higher than dedicated storage cabinets.

It is an object of the invention to reduce or even remove the above mentioned disadvantages.

This object is achieved with a pick and place unit according to claim 1.

The pick and place unit according to the invention is to be placed next to a reel storage cabinet with the cabinet access opening aligned with the access opening of the reel storage cabinet.

The means for providing an airtight connection ensures that the housing of the pick and place unit according to the invention and the housing of the storage cabinet can remain airtight even when the access opening of the storage cabinet is opened. This allows for the pick and place unit to store into or remove a reel from a large tray inside the storage cabinet, without any ambient air being mixed with the air inside of the storage cabinet.

The single reel is supplied via the reel supply opening and/or is removed via the reel discharge opening, which are both substantially smaller than the access opening of the storage cabinet.

So, with the pick and place unit according to the invention a multi-purpose storage cabinet can be used in which a number of reels are stored on large trays, while the energy costs are similar to dedicated storage cabinets, as the reel supply opening and reel discharge opening only need to be slightly larger than a single reel in order for a single reel to pass said openings.

Inside the housing of the pick and place unit according to the invention a gripper is used to grip a reel and move a gripped reel between the manipulating position and the storage cabinet. An example of such a gripper is known from US 2019/0152067.

A preferred embodiment of the pick and place unit according to the invention further comprises a first linear guide arranged in the housing and movable parallel to the cabinet access opening and a second linear guide arranged to the first linear guide, which second linear guide is movable perpendicular to the first linear guide and in a direction towards and away from the cabinet access opening, wherein the manipulator is arranged to the second linear guide.

A linear guide is considered within the invention to be, for example, a rail with a carriage running along the rail or a rod with a bushing sliding around the rod. Typically, the linear guides are actuated such that a controller can control the position of the gripper.

A further preferred embodiment of the pick and place unit according to the invention further comprises a third linear guide arranged between the second linear guide and the manipulator, which third linear guide is movable in a direction perpendicular to the first and the second linear guide.

The three perpendicular linear guides allow for the gripper to be easily positioned in each of the three dimensions of a three dimensional Cartesian coordinate system.

In another embodiment of the pick and place unit according to the invention a roller conveyor is arranged at the manipulation position, in line with the reel conveyor, which roller conveyor comprises two parallel, spaced apart rollers and a number of parallel endless snares arranged around both rollers.

The spacing between the snares allow for the gripper to be partially moved between the supporting surface of the roller conveyor, which allows for picking up or putting down a reel in either horizontal of vertical position.

Yet a further embodiment according to the invention further comprises a number of parallel, elongate elements positioned in a first position between and parallel to the endless snares, which elongate elements are rotatable around a rotation axis parallel to the rollers of the roller conveyor towards a second, upright position.

The elongate elements can bring a reel from a horizontal position into a vertical position by rotating the elongate elements from the first position to the second position. In such a vertical position, a reel could for example more easily be picked up by the gripper. The elongate elements also allow for bringing a reel from a vertical position into a horizontal position, such that the reel can be transported by the reel conveyor.

In still a further preferred embodiment of the pick and place unit according to the invention the reel supply opening and the reel discharge opening, each comprise an air tight door. These air tight doors are only opened to allow a reel to pass and minimize the time ambient air could mix with the air inside of the pick and place unit and inside of the housing of the reel storage cabinet.

In another embodiment of the pick and place unit according to the invention the means for providing an airtight connection comprise a seal arranged around the cabinet access opening. This allows for the pick and place unit to be positioned against a reel storage cabinet and with the cabinet access opening aligned with the access opening of a reel storage cabinet, while maintaining airtightness.

The invention further relates to a combination of a reel storage cabinet and a pick and place unit according to the invention, wherein the reel storage cabinet comprises an airtight housing having an access opening, a number of removable trays for holding a number of reels arranged at a number of storage positions, and a conveyor system for conveying a removable tray from a storage position in front of the access opening; and wherein the pick and place unit is arranged with the cabinet access opening aligned with the access opening of a reel storage cabinet.

Preferably the means for providing an airtight connection of the pick and place unit are formed by a combined housing of the pick and place unit and of the reel storage cabinet. When providing a combination according to the invention it is more efficient to build a single housing enclosing the reel storage as well as the pick and place unit, because less joints need to be sealed.

These and other features of the invention will be elucidated in conjunction with the accompanying drawings.
Figure 1 shows an embodiment of a combination according to the invention.
Figure 2 shows a cross-sectional view of the combination according to figure 1.
Figure 3 shows a detail in perspective view of the embodiment of figure 1.

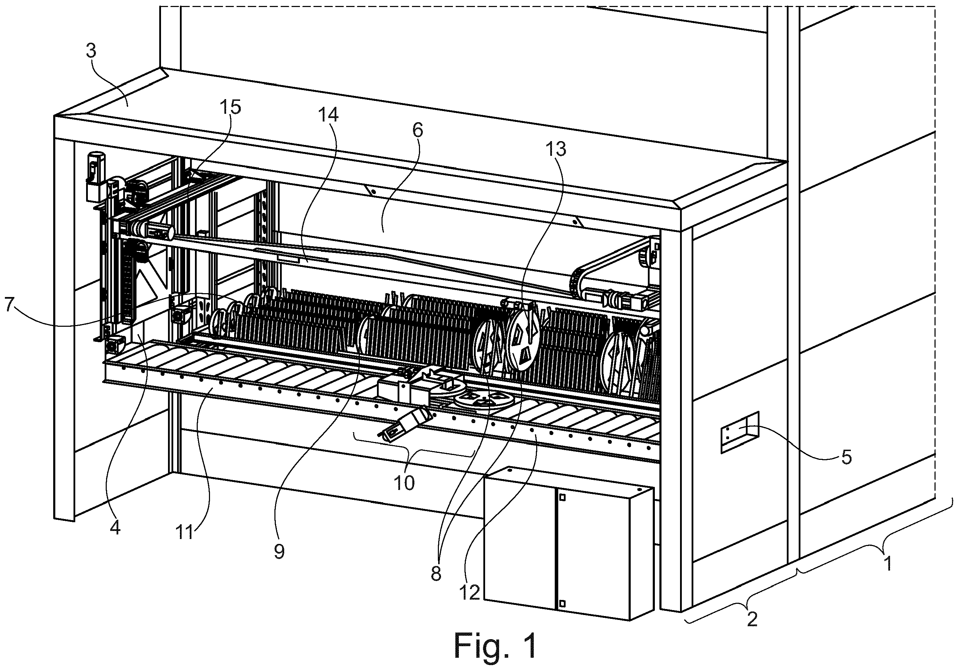

Figure 1 shows a multi-purpopse storage cabinet 1 and a pick and place unit 2 according to the invention. The pick and place unit 2 has a housing 3 with a reel supply opening 4 and a reel discharge opening 5. For clarity, the pick and place unit 2 is shown with an open front, but this front is closed during operation of the combination according to the invention.

The housing 3 furthermore has a cabinet access opening 6, which connects to the access opening of the storage cabinet 1. Inside the storage cabinet 1, a tray 7 is shown with a plurality of positions to store reels 8, 9 in vertical position.

The pick and place unit 2 is furthermore provided with a manipulation position 10 and a reel conveyor 11, 12 which extends between the reel supply opening 4, the manipulation position 10 and the reel discharge opening 5.

A gripper 13 is movable over the manipulation position 10 and the tray 7 via a first linear guide 14 extending parallel to the cabinet access opening 6 and a second linear guide 15, which extends perpendicular to the first linear guide 14.

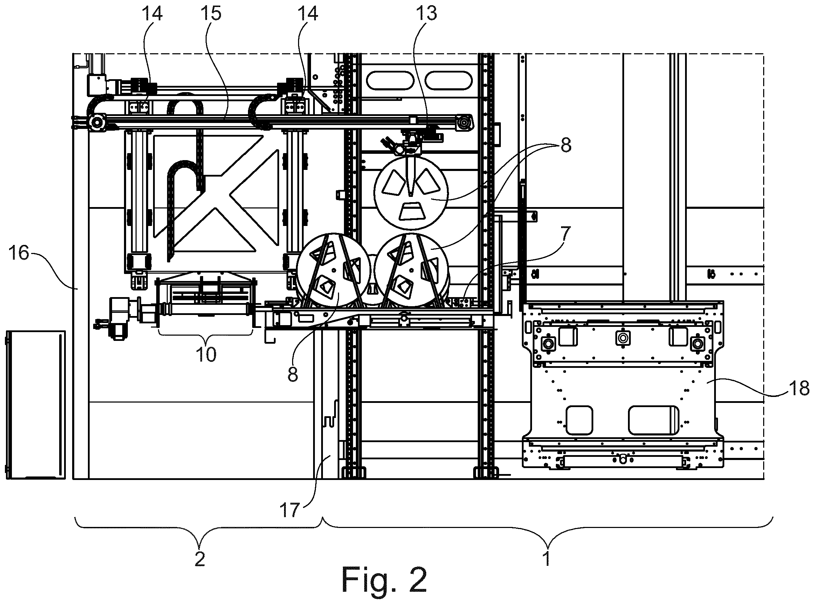

In figure 2 the combination of figure 1 is shown in cross-section. The front 16 of the pick and place unit 2 is closed with an isolated wall. A seal (not shown) is arranged at the interface surface 17 between the pick and place unit 2 and the storage cabinet 1 to ensure an airtight connection.

The storage cabinet 1 has a conveyor system 18, which can retrieve and store trays 7 between the shown position and storage positions within the housing of the storage cabinet 1.

The second linear guide 15 allows for the gripper 13 to reach into the storage cabinet 1 and grab a reel 8 from the tray and move it to the manipulation position 10 and vice versa.

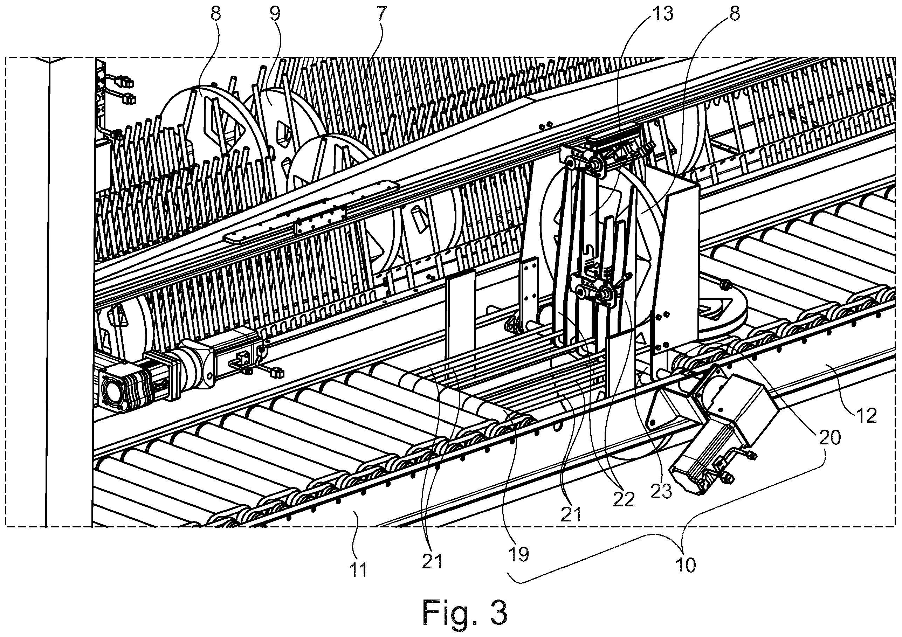

At the manipulation position 10, a roller conveyor is arranged having two parallel, spaced apart rollers 19, 20 and a number of parallel endless snares 21 arranged around both rollers 19, 20. (see figure 3)

A number of parallel, elongate elements 22 are arranged on an axis 23. The elongate elements 22 can be rotated between the shown, upright position and a position in which the elongate elements 22 are between the snares 21.

A cover tray 24 is arranged over the elongate elements 22, such that a reel 8 can be positioned from a vertical position to a horizontal position on the snares 21 and vice versa.

This allows for supply of reels 8, 9 in horizontal position, bringing the reels 8, 9 in vertical position to be stored in the tray 7. And to retrieve reels 8, 9 in vertical position from the tray 7 and position the reels 8, 9 in horizontal position onto the reel conveyor 12.

## Claims

1. Pick and place unit (2) for a reel storage cabinet (1) with an access opening, which pick and place unit (2) comprises:
- a manipulator (13) for picking and placing a single reel (8, 9) at a time; and
- a reel conveyor (11, 12); **characterized in that** the pick and place unit (2) further comprises:
- a housing (3) with a reel supply opening (4), a reel discharge opening (5) and a cabinet access opening (6);
- means for providing an airtight connection of the cabinet access opening (6) with the access opening of the reel storage cabinet (1);
wherein the manipulator (13) is arranged in the housing (3), which manipulator (13) is movable between a first position extending from the housing (3) through the cabinet access opening (6) for picking and placing a reel (8, 9) from and into the reel storage cabinet (1) and a second position within the housing (3) for picking and placing a reel (8, 9) from and onto a manipulating position (10);
wherein the reel conveyor (11, 12) is arranged between the reel supply opening (4) and the manipulation position (10) and between the manipulation position (10) and the reel discharge opening (5).

2. Pick and place unit (2) according to claim 1, further comprising a first linear guide (14) arranged in the housing (3) and movable parallel to the cabinet access opening and a second linear guide (15) arranged to the first linear guide (14), which second linear guide (15) is movable perpendicular to the first linear guide (14) and in a direction towards and away from the cabinet access opening (6), wherein the manipulator (13) is arranged to the second linear guide (15).

3. Pick and place unit (2) according to claim 2, further comprising a third linear guide arranged between the second linear guide (15) and the manipulator (13), which third linear guide is movable in a direction perpendicular to the first (14) and the second (15) linear guide.

4. Pick and place unit (2) according to any of the preceding claims, wherein a roller conveyor (19, 20) is arranged at the manipulation position (10), in line with the reel conveyor (11, 12), which roller conveyor (19, 20) comprises two parallel, spaced apart rollers (19, 20) and a number of parallel endless snares (21) arranged around both rollers (19, 20).

5. Pick and place unit (2) according to claim 4, further comprising a number of parallel, elongate elements (22) positioned in a first position between and parallel to the endless snares (21), which elongate elements (22) are rotatable around a rotation axis (23) parallel to the rollers (19, 20) of the roller conveyor towards a second, upright position.

6. Pick and place unit (2) according to any of the preceding claims, wherein the reel supply opening (4) and the reel discharge opening (5), each comprise an air tight door.

7. Pick and place unit (2) according to any of the preceding claims, wherein the means for providing an airtight connection comprise a seal arranged around the cabinet access opening (6).

8. Combination of a reel storage cabinet (1) and a pick and place unit (2) according to any of the preceding claims, wherein the reel storage cabinet (1) comprises an airtight housing having an access opening, a number of removable trays (7) for holding a number of reels (8, 9) arranged at a number of storage positions, and a conveyor system (18) for conveying a removable tray (7) from a storage position in front of the access opening; and wherein the pick and place unit (2) is arranged with the cabinet access opening (6) aligned with the access opening of a reel storage cabinet (1) .

9. Combination according to claim 8, wherein the means for providing an airtight connection of the pick and place unit are formed by a combined housing of the pick and place unit (2) and of the reel storage cabinet (1).

## Patentansprüche

1. Bestückungseinheit (2) für einen Rollenlagerschrank (1) mit einer Zugangsöffnung, wobei die Bestückungseinheit (2) Folgendes umfasst:
- einen Manipulator (13) zum Aufnehmen und Platzieren jeweils einer einzelnen Rolle (8, 9); und
- einen Rollenförderer (11, 12);
**dadurch gekennzeichnet, dass** die Bestückungseinheit (2) weiter Folgendes umfasst:
- ein Gehäuse (3) mit einer Rollenzufuhröffnung (4), einer Rollenausgabeöffnung (5) und einer Schrankzugangsöffnung (6);
- Mittel zum Bereitstellen einer luftdichten Verbindung der Schrankzugangsöffnung (6) mit der Zugangsöffnung des Rollenlagerschranks (1);
wobei der Manipulator (13) im Gehäuse (3) angeordnet ist, wobei der Manipulator (13) zwischen einer ersten Position, die sich vom Gehäuse (3) durch die Schrankzugangsöffnung (6) erstreckt, zum Aufnehmen und Platzieren einer Rolle (8, 9) aus und in den Rollenlagerschrank (1), und in eine zweite Position innerhalb des Gehäuses (3) zum Aufnehmen und Platzieren einer Rolle (8, 9 aus und in eine Manipulationsposition (10) bewegbar ist;
wobei der Rollenförderer (11, 12) zwischen der Rollenzufuhröffnung (4) und der Manipulationsposition (10) und zwischen der Manipulationsposition (10) und der Rollenausgabeöffnung (5) angeordnet ist.

2. Bestückungseinheit (2) nach Anspruch 1, die weiter eine erste Linearführung (14), die im Gehäuse (3) angeordnet und parallel zur Schrankzugangsöffnung bewegbar ist, und eine zweite Linearführung (15) umfasst, die an der ersten Linearführung (14) angeordnet ist, wobei die zweite Linearführung (15) senkrecht zur ersten Linearführung (14) und in einer Richtung auf die Schrankzugangsöffnung (6) zu und von dieser weg bewegbar ist, wobei der Manipulator (13) an der zweiten Linearführung (15) angeordnet ist.

3. Bestückungseinheit (2) nach Anspruch 2, die weiter eine dritte Linearführung umfasst, die zwischen der zweiten Linearführung (15) und dem Manipulator (13) angeordnet ist, wobei die dritte Linearführung in einer Richtung senkrecht zur ersten (14) und zweiten (15) Linearführung bewegbar ist.

4. Bestückungseinheit (2) nach einem der vorstehenden Ansprüche, wobei ein Walzenförderer (19, 20) an der Manipulationsposition (10) ausgerichtet auf den Rollenförderer (11, 12) angeordnet ist, wobei der Walzenförderer (19, 20) zwei parallele, beabstandete Walzen (19, 20) und eine Anzahl paralleler Endlosschlingen (21) umfasst, die um beide Walzen (19, 20) herum angeordnet sind.

5. Bestückungseinheit (2) nach Anspruch 4, die weiter eine Anzahl paralleler, länglicher Elemente (22) umfasst, die in einer ersten Position zwischen und parallel zu den Endlosschlingen (21) positioniert sind, wobei die länglichen Elemente (22) um eine Drehachse (23) parallel zu den Walzen (19, 20) des Walzenförderers in eine zweite, aufrechte Position drehbar sind.

6. Bestückungseinheit (2) nach einem der vorstehenden Ansprüche, wobei die Rollenzufuhröffnung (4) und die Rollenausgabeöffnung (5) jeweils eine luftdichte Tür umfassen.

7. Bestückungseinheit (2) nach einem der vorstehenden Ansprüche, wobei die Mittel zum Bereitstellen einer luftdichten Verbindung eine um die Schrankzugangsöffnung (6) angeordnete Dichtung umfassen.

8. Kombination aus einem Rollenlagerschrank (1) und einer Bestückungseinheit (2) nach einem der vorstehenden Ansprüche, wobei der Rollenlagerschrank (1) ein luftdichtes Gehäuse mit einer Zugangsöffnung, eine Anzahl herausnehmbarer Trays (7) zum Halten einer Anzahl von Rollen (8, 9), die an einer Anzahl von Lagerpositionen angeordnet sind, und ein Fördersystem (18) zum Fördern eines herausnehmbaren Trays (7) aus einer Lagerposition vor der Zugangsöffnung umfasst; und wobei die Bestückungseinheit (2) so angeordnet ist, dass die Schrankzugangsöffnung (6) mit der Zugangsöffnung eines Rollenlagerschranks (1) ausgerichtet ist.

9. Kombination nach Anspruch 8, wobei die Mittel zum Bereitstellen einer luftdichten Verbindung der Bestückungseinheit durch ein kombiniertes Gehäuse der Bestückungseinheit (2) und des Rollenlagerschranks (1) gebildet sind.

## Revendications

1. Unité de prélèvement et de mise en place (2) pour une armoire de stockage de bobines (1) avec un orifice d'accès, laquelle unité de prélèvement et de mise en place (2) comprend :
- un manipulateur (13) pour prélever et mettre en place une seule bobine (8, 9) à la fois ; et
- un convoyeur de bobine (11, 12) ;
**caractérisée en ce que** l'unité de prélèvement et de mise en place (2) comprend en outre :
- un boîtier (3) avec un orifice de fourniture de bobine (4), un orifice d'évacuation de bobine (5) et un orifice d'accès à l'armoire (6) ;
- des moyens pour fournir une connexion étanche à l'air de l'orifice d'accès à l'armoire (6) avec l'orifice d'accès de l'armoire de stockage de bobines (1) ;
dans laquelle le manipulateur (13) est agencé dans le boîtier (3), lequel manipulateur (13) est mobile entre une première position s'étendant depuis le boîtier (3) à travers l'orifice d'accès à l'armoire (6) pour prélever et mettre en place une bobine (8, 9) depuis et dans l'armoire de stockage de bobines (1), et une seconde position à l'intérieur du boîtier (3) pour prélever et mettre en place une bobine (8, 9) depuis et sur une position de manipulation (10) ;
dans laquelle le convoyeur de bobine (11, 12) est agencé entre l'orifice de fourniture de bobine (4) et la position de manipulation (10) et entre la position de manipulation (10) et l'orifice d'évacuation de bobine (5).

2. Unité de prélèvement et de mise en place (2) selon la revendication 1, comprenant en outre un premier guide linéaire (14) agencé dans le boîtier (3) et mobile parallèlement à l'orifice d'accès à l'armoire et un deuxième guide linéaire (15) agencé par rapport au premier guide linéaire (14), lequel deuxième guide linéaire (15) est mobile perpendiculairement au premier guide linéaire (14) et dans une direction allant vers, et à l'opposé de, l'orifice d'accès à l'armoire (6), dans laquelle le manipulateur (13) est agencé par rapport au deuxième guide linéaire (15).

3. Unité de prélèvement et de mise en place (2) selon la revendication 2, comprenant en outre un troisième guide linéaire agencé entre le deuxième guide linéaire (15) et le manipulateur (13), lequel troisième guide linéaire est mobile dans une direction perpendiculaire au premier (14) et au deuxième (15) guide linéaire.

4. Unité de prélèvement et de mise en place (2) selon l'une quelconque des revendications précédentes, dans laquelle un convoyeur à rouleaux (19, 20) est agencé au niveau de la position de manipulation (10), en ligne avec le convoyeur de bobine (11, 12), lequel convoyeur de bobine ( 19, 20) comprend deux rouleaux parallèles espacés (19, 20) et un certain nombre de lacets sans fin parallèles (21) agencés autour des deux rouleaux (19, 20).

5. Unité de prélèvement et de mise en place (2) selon la revendication 4, comprenant en outre un certain nombre d'éléments allongés parallèles (22) positionnés dans une première position entre les lacets sans fin (21), et parallèlement à ceux-ci, lesquels éléments allongés (22) peuvent tourner autour d'un axe de rotation (23) parallèle aux rouleaux (19, 20) du convoyeur à rouleaux vers une seconde position verticale.

6. Unité de prélèvement et de mise en place (2) selon l'une quelconque des revendications précédentes, dans laquelle l'orifice de fourniture de bobine (4) et l'orifice d'évacuation de bobine (5) comprennent chacun une porte étanche à l'air.

7. Unité de prélèvement et de mise en place (2) selon l'une quelconque des revendications précédentes, dans laquelle les moyens pour fournir une connexion étanche à l'air comprennent un joint d'étanchéité agencé autour de l'orifice d'accès à l'armoire (6).

8. Combinaison d'une armoire de stockage de bobines (1) et d'une unité de prélèvement et de mise en place (2) selon l'une quelconque des revendications précédentes, dans laquelle l'armoire de stockage de bobines (1) comprend un boîtier étanche à l'air présentant un orifice d'accès, un certain nombre de plateaux amovibles (7) pour contenir un certain nombre de bobines (8, 9) agencés à un certain nombre de positions de stockage, et un système de convoyeur (18) pour transporter un plateau amovible (7) depuis une position de stockage devant l'orifice d'accès ; et dans laquelle l'unité de prélèvement et de mise en place (2) est agencée avec l'orifice d'accès à l'armoire (6) alignée sur l'orifice d'accès d'une armoire de stockage de bobines (1).

9. Combinaison selon la revendication 8, dans laquelle les moyens pour fournir une connexion étanche à l'air de l'unité de prélèvement et de mise en place sont formés par un boîtier combiné de l'unité de prélèvement et de mise en place (2) et de l'armoire de stockage de bobines (1).
